# EUROPEAN PATENT SPECIFICATION

(11) **EP 1 548 888 B1**
(45) Date of publication and mention of the grant of the patent: **31.10.2007**
(21) Application number: 04106816.4
(22) Date of filing: 21.12.2004
(51) Int. Cl.: H01R 12/16, H01R 13/193, H05K 7/10

(54) **PGA Type IC Socket**
Gitterstiftsockel für integrierte Schaltung
Support de matrice de broches pour circuit intégré

(30) Priority: 26.12.2003 JP 2003432374; 12.11.2004 JP 2004328410
(43) Date of publication of application: 29.06.2005
(73) Proprietor: Tyco Electronics AMP K.K., Kawasaki-shi, Kanagawa 213-8535 (JP)
(72) Inventor: Hashimoto, Shinichi, 213-8535, Kawasaki-shi (JP)
(74) Representative: Johnstone, Douglas Ian

(56) References cited:
- EP-A- 0 453 671
- US-A- 5 013 256
- US-A- 5 588 861
- US-A- 6 142 810
- US-A1- 2003 186 571
- US-A1- 2003 232 529

## Description

The present invention relates to an IC socket, having a great number of socket contacts arranged in a matrix. Particularly, the present invention relates to a PGA (Pin Grid Array) type IC socket, to which lead pins of an IC package (electrical device) are mounted in the socket contacts with zero or low insertion force, then electrically connects the contacts with each other by moving the IC package in the horizontal direction.

There is known a PGA type IC socket as disclosed in US-A-5,299,950 (Figures 1 and 6A). This IC socket comprises socket contacts, having pairs of elastic contact pieces and a connecting portion, which is formed in a substantially C-shape in plan view, for connecting the elastic contact pieces. This IC socket further comprises cavities, which are arranged in a matrix (two dimensionally), and each of the socket contacts are housed within the cavities. Lead pins of an IC package are inserted into proximal end portions of the pairs of elastic contact pieces, where the gaps therebetween are comparatively wide, with zero or low insertion force. Next, the lead pins are moved toward the distal ends of the elastic contact piece pairs, where the gaps therebetween are narrow. Thereby, the lead pins are electrically connected with the socket contacts and held between the distal ends of the elastic contact pieces. In this known PGA type IC socket, housing walls of the cavities, in the proximity of the distal ends of the elastic contact pieces, prevent disengagement of the lead pins from the socket contacts, and also position the IC package. Accordingly, the housing walls that form the cavities are indispensable.

In the known IC socket described above, there is a possibility that the lead pins will interfere with the cavity walls during insertion and horizontal movement of the lead pins. Therefore it is necessary to secure a certain size for the cavities. Accordingly, there is difficulty in arranging the socket contacts at high density, by providing them at narrow pitches, due to dimensional restraints.

US-A-5013256 and 5588861 and EP-A-0453671 disclose PGA type IC sockets, each of which comprises a socket housing mounting a plurality of resilient contacts for engaging lead pins of another electrical device. The contacts are housed in cavities arranged in a two-dimensional array in the same orientation. The other electrical device is mounted on a drive or cover plate slidable on the socket housing for moving the lead pins of the other device in a direction perpendicular to the insertion direction thereof into the drive plate. The socket is designed to enable zero insertion force for the lead pins of the other electrical device into the socket housing, whereupon the drive plate is moved perpendicular to the insertion direction and forcefully to engage the lead pins with the socket contacts. In the socket, for example, of US-A-5013256, the zero insertion force spaces are defined by cut-outs formed in walls of the socket cavities facing the drive plate, such that cavities which are adjacent to each other in the perpendicular direction are in communication with each other.

The present invention has been developed in view of the above circumstances. It is an object of the present invention to provide a PGA type IC socket in which it is possible to arrange socket contacts at high density.

It is another object of the present invention to provide a PGA type IC socket by which IC packages can be positioned without inhibiting the high density arrangement of socket contacts.

The present invention resides in a PGA type IC socket as set forth in claim 1 hereof.

A preferred embodiment may include stopper walls for abutting lead pins which are not involved in the electrical contact with the socket contacts.

It is preferable that the dimensions of the cutouts in the insertion direction of the lead pins are greater than the insertion depth of the lead pins.

It is also preferable that each of the elastic contact pairs comprise a base, held in the cavity, having an upper edge at substantially the same position as the inner edge of the cutout; base end portions that extend in the horizontal direction from the upper edge of the base; and lead pin contact portions which are formed to extend upward from the base end portion and inclined such that they approach each other toward their distal ends.

Note that here, the "electrical device" refers to an IC package, having a great number of lead pins.

The PGA type IC socket of the present invention comprises: socket contacts, each having a pair of narrowly spaced elastic contact pieces for contacting lead pins, which have been moved in the perpendicular direction; a socket housing having a great number of cavities, which are arranged in a two-dimensional arrangement (two dimensionally) for holding the socket contacts; and cutouts formed in the walls of the cavities toward the electrical device, such that cavities, which are adjacent to each other in a direction perpendicular to lead pins of the electrical device, are in communication with each other. Therefore, the PGA type IC socket exhibits the following advantageous effects.

The cutouts are formed in the walls of the cavities toward the electrical device such that cavities, which are adjacent to each other in the direction of horizontal movement of the lead pins, are in communication with each other. Therefore, when mounting the electrical device onto the IC socket, interference of the lead pins with the cavity walls is avoided. Thereby, the dimensions of the cavities in the moving direction of the lead pins can be minimized. Accordingly, a PGA type IC socket, in which socket contacts are arranged at high density, is provided.

Stoppers are formed at the distal ends of the elastic contact pieces. In this case, disengagement of the lead pins during insertion and movement in the perpendicular direction (the horizontal direction) is prevented by the stoppers of the socket contacts. The stoppers, which are relatively small in size, are formed as positioning means for the lead pins (the IC package) . Accordingly, the IC package can be positioned, without inhibiting the high density arrangement of the socket contacts.

Stopper walls, for abutting lead pins which are not involved in the electrical contact with the socket contacts, may be provided. In this case, lead pins (dummy lead pins), which are unavoidably provided in the IC package may be employed as stopper means for the IC package, without inhibiting the high density arrangement of the socket contacts.

The dimensions of the cutouts in the insertion direction of the lead pins may be greater than the insertion depth of the lead pins. In this case, interference of the lead pins with the cavity walls is positively avoided. Therefore, the socket contacts can be arranged at even higher density.

In the accompanying drawings:-
Figure 1 is a plan view of an IC socket according to a first embodiment of the present invention.
Figure 2 is a front view of the IC socket of Figure 1.
Figures 3A, 3B, and 3C illustrate a socket contact utilized in the IC socket of Figure 1, wherein Figure 3A is a side view, Figure 3B is a front view, and Figure 3C is a plan view.
Figure 4 is a partial magnified sectional view of the IC socket, in which the socket contacts of Figure 3 are provided.
Figure 5 is a partial plan view of a socket housing, in which the socket contacts of Figure 3 are provided.
Figure 6 is a partial plan view of the IC socket according to the first embodiment, corresponding to Figure 5.
Figure 7 is a partial magnified sectional view taken along line VII-VII of Figure 5, and also illustrates a slide cover.
Figure 8 is a partial magnified sectional view, corresponding to Figure 4, that illustrates the state after the slide cover has been moved.
Figure 9 is a partial plan view, corresponding to Figure 6, that illustrates the state after the slide cover has been moved.
Figures 10A and 10B are partial magnified sectional views of another IC socket, wherein Figure 10A illustrates a state prior to a slide cover being moved, and Figure 10B illustrates a state after the slide cover has been moved.
Figures 11A, 11B, and 11C illustrate the socket contact utilized in the IC socket of Figures 10A and 10B, wherein Figure 11A is a side view, Figure 11B is a front view, and Figure 11C is a plan view.
Figures 12A and 12B are partial magnified sectional views of an IC socket according to a second embodiment of the present invention, wherein Figure 12A illustrates a state in which a slide cover is in its initial position, and Figure 10B illustrates a state after the slide cover has been driven and moved to its final position.
Figures 13A, 13B, and 13C illustrate a socket contact, which is utilized in the IC socket of Figures 12A and 12B, wherein Figure 13A is a plan view, Figure 13B is a front view, and Figure 13C is a side view.

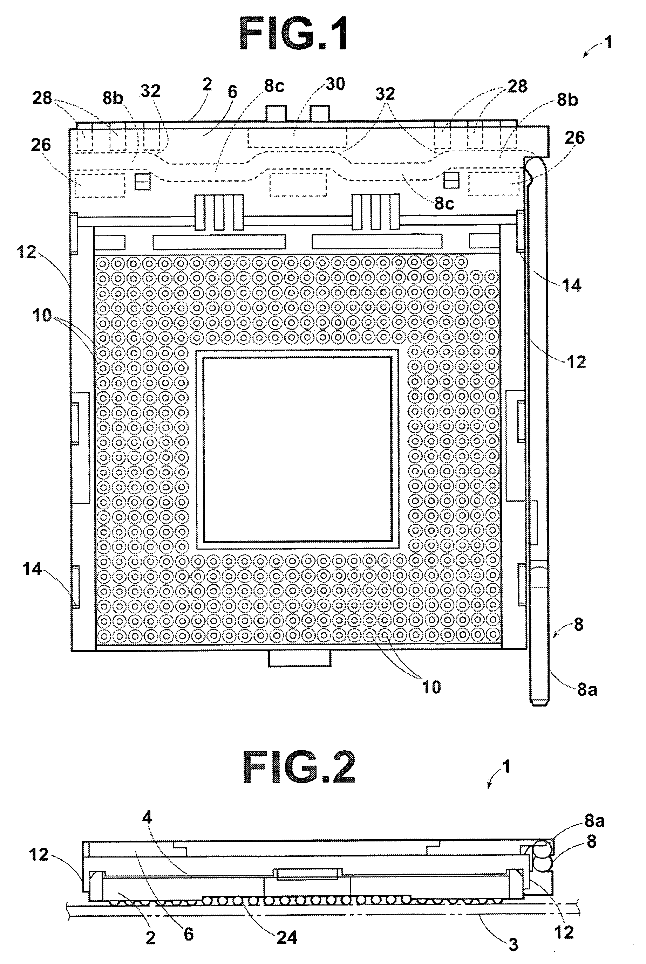

Hereinafter, a first embodiment of the PGA type IC socket (hereinafter, simply referred to as "IC socket") of the present invention will be described in detail with reference to the attached drawings. Figure 1 is a plan view of the IC socket 1 of the first embodiment. Figure 2 is a front view of the IC socket 1 of Figure 1. A description will be given with reference to Figure 1 and Figure 2.

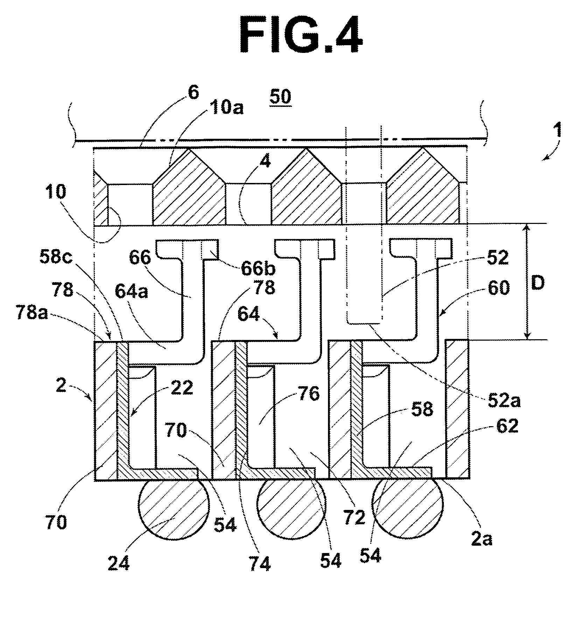

The IC socket 1 comprises an insulative socket housing 2; and a slide cover 6. The slide cover 6 is placed on an upper surface 4 of the socket housing 2 and configured to slide along the upper surface 4. The IC socket 1 further comprises a lever 8, for sliding the slide cover 6. The slide cover 6 has a great number (plurality or multiplicity) of circular apertures 10 (refer to Figure 1) therethrough, arranged in a matrix. The apertures 10 are for lead pins 52 (refer to Figure 4), which are the pin type electrical contacts of an IC package 50 (electrical device), to be inserted through. Note that the slide cover 6 and the lever 8, for moving the lead pins 52 in a direction perpendicular to their insertion direction, are referred to as a drive portion.

The slide cover 6 comprises side walls 12 that extend along the exterior of the socket housing 2. A plurality of long rectangular holes 14 that extend in the sliding direction of the sliding cover 6, that is, the vertical direction in Figure 1, are formed in each of the side walls 12. The holes 14 engage with corresponding protrusions (not shown) of the socket housing 2, and the slide cover 6 is mounted so as to be slidable with respect to the socket housing 2, in the vertical direction in Figure 1.

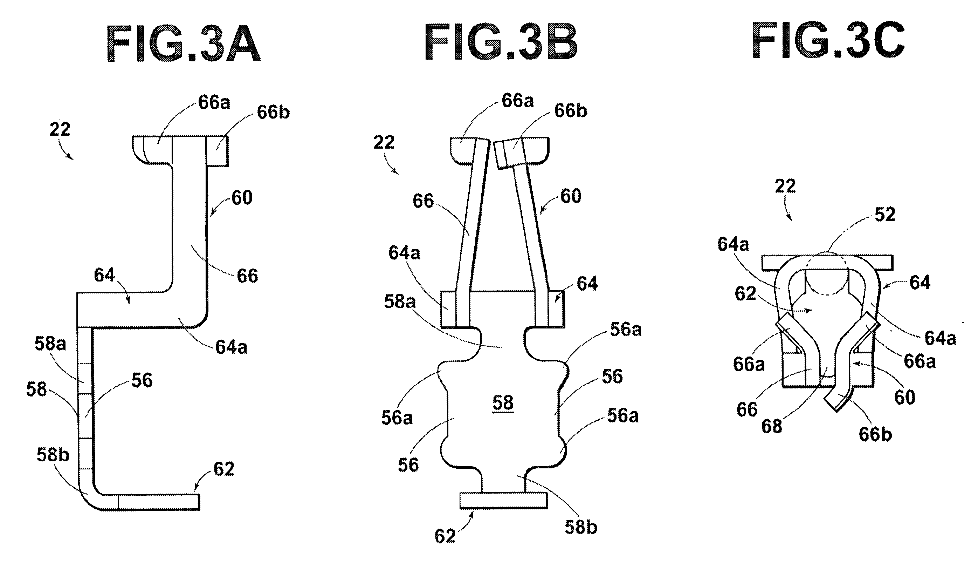

A great number (plurality or multiplicity) of socket contacts 22 (refer to Figures 3A, 3B, and 3C) are provided in the socket housing 2, corresponding to the apertures 10. Each of the socket contacts 22 has a solder ball 24, which is to be soldered to a circuit board 3, at the lower edge thereof. A plurality of block shaped protrusions 26, 28, and 30 (refer to Figure 1) are integrally formed with the socket housing 2 at the edges of the upper surface 4 thereof. These protrusions 26, 28, and 30 form a lever holding groove 32.

Meanwhile, the lever 8 is constituted by a rod like metallic member having a circular cross section and which is formed into an L shape. An operating portion 8a, formed at a first end, is provided on the side of one of the side walls 12, while a second end is provided in the lever holding groove 32, to serve as a support shaft 8b, about which the lever 8 rotates. Cam shafts 8c and 8c, which are partially offset from the support shaft 8b, are integrally formed with the support shaft 8b. When the lever 8 is operated and rotated, the cam shafts 8c engage the slide cover 6. The slide cover 6 is configured to slide with respect to the socket housing 2 by being driven by the cam shafts 8c. This technique is commonly applied; therefore, a detailed description of this structure will be omitted.

Mounting of the IC package 50 is performed as follows. First, the lever 8 is rotated 90 degrees upward from the position illustrated in Figure 1. Then, the IC package 50 is placed on the slide cover 6 with zero or low insertion force. Thereafter, the lever 8 is rotated back to the position illustrated in Figure 1, thereby establishing electrical connections between the lead pins 52 (refer to Figure 4) of the IC package 50 and the socket contacts 22 of the IC socket 1. The electrical connecting structure that employs the lever 8 is well known as an LIF (Low Insertion Force) connector or as a ZIF (Zero Insertion Force) connector; therefore, a detailed description will be omitted.

Next, the socket contacts 22, which are provided within the cavities 54 (refer to Figure 4) of the socket housing 2, will be described with reference to Figures 3A, 3B, and 3C. Figures 3A, 3B, and 3C illustrate the socket contact 22 utilized in the IC socket 1 of Figure 1, wherein Figure 3A is a side view, Figure 3B is a front view, and Figure 3C is a plan view. Each of the socket contacts 22 is formed by punching and bending a single resilient metallic plate. The socket contact 22 comprises a planar base 58; an elastic contact piece 60, which is formed at the upper portion of the base 58; and a leg portion 62, which is formed at the lower portion of the base 58, all of which are integrally formed. The base 58 has a pair of engaging protrusions 56a on each of its side edges 56.

The elastic contact piece 60 comprises a base end portion 64, which is bent in two directions to extend perpendicular to and horizontally away from the base 58 via a constricted portion 58a; and lead pin contact portions 66 that extend upward from the base end portion 64 and approach each other toward their distal ends. Here, the expressions "up" and "down" are utilized for convenience in the description, and refer to the upward and downward directions in Figures 3A and 3B. The base end portion 64 comprises a pair of arms 64a with a gap, which is greater than the diameter of the lead pins 52 (refer to Figure 4), therebetween. The arms 64a converge slightly at the free ends thereof.

The lead pin contact portions 66 have a substantially parallel gap 68 therebetween, as illustrated in Figure 3C. A pair of guide pieces 66a are formed at the distal ends of the lead pin contact portions 66, in a manner such that they spread toward the base end portion 64. The guide pieces 66a guide the lead pin 52, which has been inserted, during its movement in the direction perpendicular to its insertion direction, that is, during horizontal movement of the lead pin 52. A stopper piece 66b is formed on the side of the distal end opposite the guide pieces 66a, on at least one of the elastic contact pieces 60. The stopper piece 66b is inwardly inclined, that is, inclined toward the gap 68. The leg portion 62 is substantially rectangular in plan view, as is clear from Figure 3C. The leg portion 62 is formed so as to be bent, via the constricted portion 58b, perpendicular to the base 58 in the same direction as the base end portion 64.

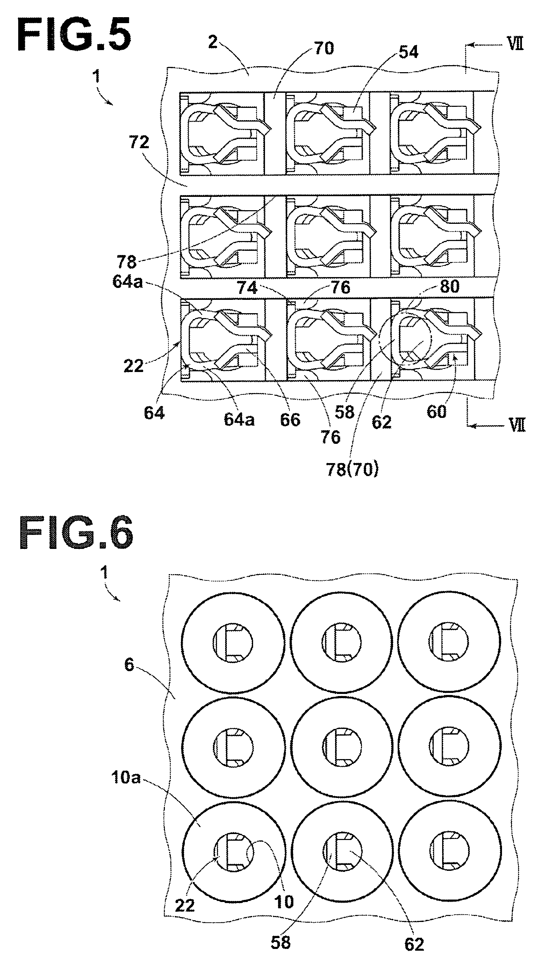

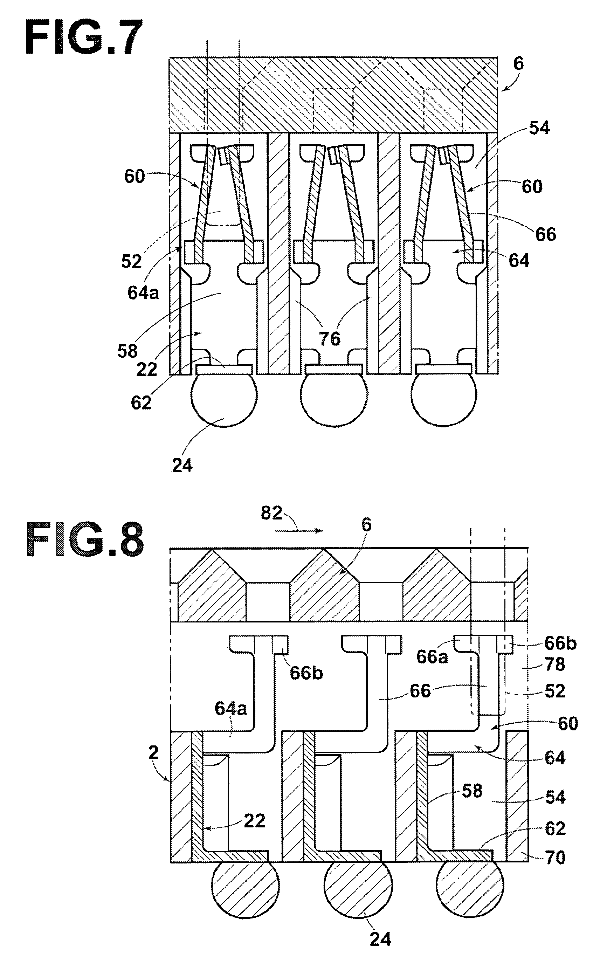

Next, the state in which the socket contacts 22 are provided in the socket housing 2 will be described with reference to Figures 4 through 7. Figure 4 is a partial magnified sectional view of the IC socket 1, in which the socket contacts 22 are provided. Figure 5 is a partial plan view of the socket housing, in which the socket contacts 22 are provided. Figure 6 is a partial plan view of the IC socket 1, corresponding to Figure 5. Figure 7 is a partial magnified sectional view taken along line VII-VII of Figure 5, and also illustrates the slide cover 6.

As illustrated in Figure 4, the cavities 54 are formed in the socket housing 2. The socket contacts 22 are provided within the cavities 54. The slide cover 6 is mounted on the upper surface 4 of the socket housing 2.

First, the socket housing 2 will be described in detail. As illustrated in Figure 4, the cavities 54 penetrate through the socket housing 2 in the vertical direction. Adjacent cavities 54 are separated by walls 70 and 72. The walls 70 separate the cavities 54 in the direction along the horizontal movement of the lead pins 52. A pair of bloated portions 76 are formed adjacent to each of the walls 70. Contact receiving grooves 74 are formed by the walls 70 and the bloated portions 76. The socket contacts 22 are press fit within the contact receiving grooves 74 from above, and the engaging protrusions 56a (refer to Figure 3B) engage with the contact receiving grooves 74 to fix the socket contacts 22 therein. At this time, the leg portions 62 are positioned so as to cross the cavities 54 at the lower surface 2a of the socket housing 2. The solder balls 24 are formed on the lower surfaces of the leg portions 62. The elastic contact pieces 60 are positioned so that the arms 64a cross the cavities 54, and the lead pin contact portions 66 are positioned toward another adjacent wall 70.

What is important here is that cutouts 78, which are open toward the IC package 50, are formed in the walls 70 of the cavities 54. The cutouts 78 are in the movement paths of the lead pins 52. The plurality of cavities 54 communicate with each other via the cutouts 78. The dimensions of the cutouts 78, that is, the depth D (refer to Figure 4) from the upper surface 4 of the socket housing 2 to the lower edges (inner edges) 78a of the cutouts 78, is approximately 1/2 the thickness of the socket housing 2 in the vertical direction. The cutouts 78 are deep enough to reach the upper edges 58c (refer to Figure 4) of the bases 58 of the socket contacts 22. The stopper pieces 66b of the elastic contact pieces 60 are positioned within the cutout 78 of another adjacent wall 70.

The elastic contact pieces 60 of the socket contacts 22 have the following configuration with respect to the socket housing 2. Each of the elastic contact pieces 60 comprises the base 58, which is held in the cavity 54 and has its upper edge 58c at substantially the same position as the inner edge 78a of the cutout 78; the base end portion 64 that extends horizontally from the upper edge of the base 58; and the lead pin contact portions 66, which are formed to extend upward from the base end portion and which are inclined such that they approach each other toward their distal ends. Because of this configuration, the lead pins 52 do not contact the socket contacts 22 during insertion into the socket housing 2. Therefore, insertion can be accomplished with zero insertion force.

The slide cover 6 illustrated in Figure 4 is in its initial position, that is, the position prior to sliding movement thereof. The apertures 10 are positioned substantially above the bases 58 of the socket contacts 22. Tapers 10a, for guiding the lead pins 52, are formed at the peripheries of the apertures 10. When a lead pin 52 is inserted through the aperture 10, as illustrated by broken lines, the wall 70 does not interfere therewith, as the cutout 78 is formed in the movement path of the lead pin 52. In addition, the lead pin 52 does not abut the cutout 78, because the distal end 52a thereof does not reach the depth D of the cutout 78. Further, the lead pin 52 is positioned between the pair of elastic contact pieces 60, as illustrated in Figure 7. Note that the region 80, illustrated by the broken line in Figure 5, indicates the region at which the lead pin 52 is inserted, and partially overlaps the wall 70. It can be seen from this also that the cutout 78 operates effectively during insertion of the lead pin 52.

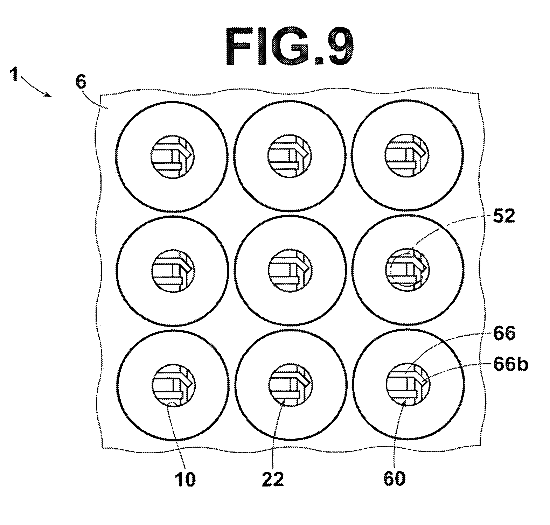

Next, the state in which the slide cover 6 has been moved will be described with reference to Figure 8 and Figure 9. Figure 8 is a partial magnified sectional view, corresponding to Figure 4, that illustrates the state after the slide cover 6 has been moved. Figure 9 is a partial plan view, corresponding to Figure 6, that illustrates the state after the slide cover 6 has been moved. When the slide cover 6 completes its movement in the direction of arrow 82, the lead pins 52 are guided by the guide pieces 66a, to move between the pair of elastic contact pieces 60. The lead pins 52 contact the lead pin contact portions 66, and are held therebetween. At this time, the cutouts 78 prevent interference between the lead pins 52 and the walls 70. In addition, the stopper pieces 66b prevent further movement of the lead pins 52 in the direction of arrow 82, thereby preventing disengagement of the lead pins 52 from the elastic contact pieces 60. In Figure 9, the lead pin 52 is illustrated by broken lines, and the lead pin contact portions 66 are shown in their closed state, prior to contact with the lead pin 52. It can be clearly seen from Figure 9 that when the lead pin 52 is held by the lead pin contact portions 66, the stopper piece 66b prevents disengagement of the lead pin 52.

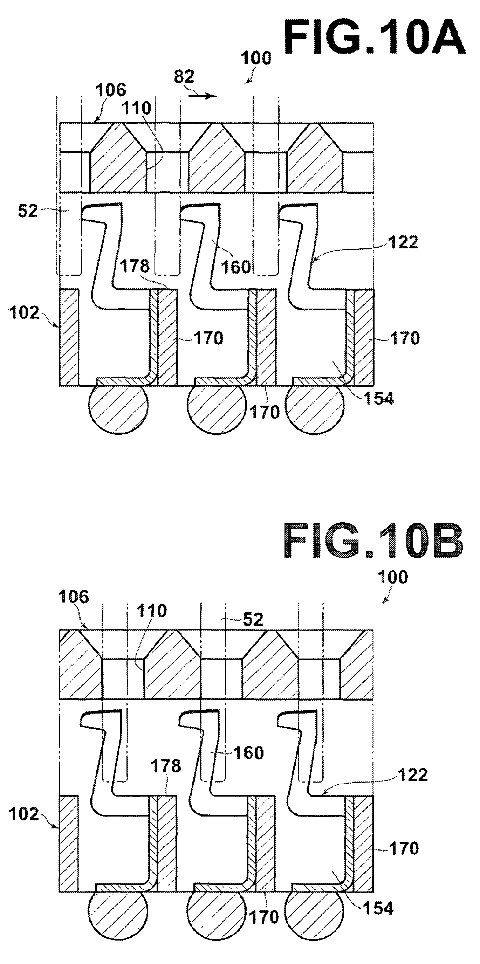

Next, an IC socket 100 will be described with reference to Figures 10A and 10B. Figures 10A and 10B are partial magnified sectional views of the IC socket 100, in which socket contacts 122 have been provided, wherein Figure 10A illustrates a state prior to a slide cover 106 being moved, and Figure 10B illustrates a state after the slide cover 106 has been moved. The main difference between the IC socket 1 of the first embodiment and the IC socket 100 is in the shape of the socket contacts 122. That is, the socket contacts 122 do not have parts that correspond to the stopper pieces 66b of the first embodiment. In other words, the IC socket 100 is not provided with a positioning means for the lead pins 52 nor for the IC package 50.

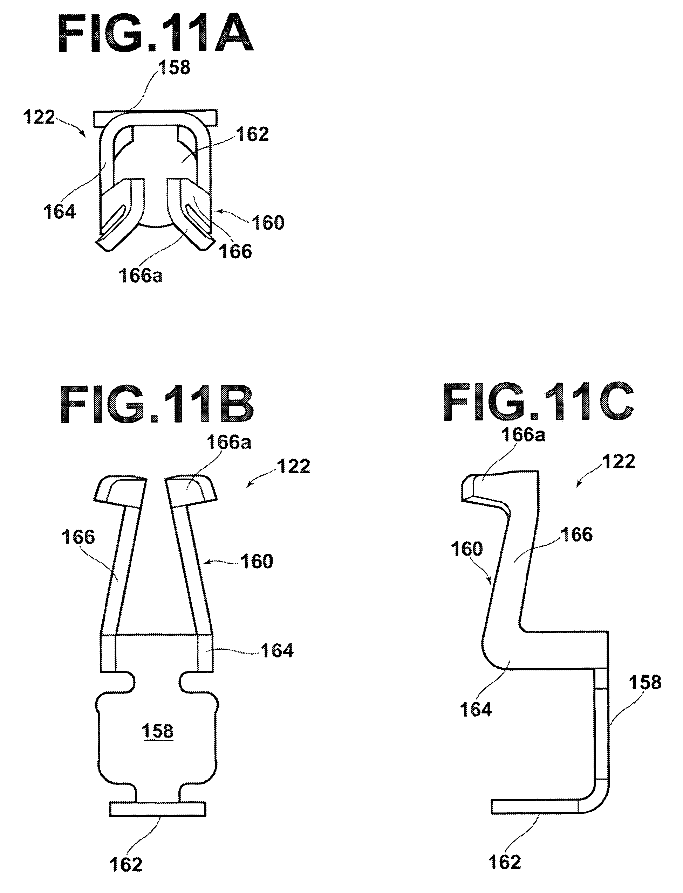

First, the socket contacts 122 will be described with reference to Figures 11A, 11B, and 11C. Figures 11A, 11B, and 11C illustrate the socket contact 122 utilized in the IC socket 100, wherein Figure 11A is a side view, Figure 11B is a front view, and Figure 11C is a plan view. Note that the following description will be based mainly on the differences between the socket contacts 22 of the first embodiment and the socket contacts 122 of socket 100. Each of the socket contacts 122 comprises: a base 158; a leg portion 162 at the lower portion of the base 158; and a pair of elastic contact pieces 160 at the upper portion of the base 158. Each of the elastic contact pieces 160 comprises a base end portion 164 that extends in the same direction as the leg portion 162; and a lead pin contact portion 166 that extends upwardly while being slightly inclined. The lead pin contact portions 166 have spread open guide pieces 166a, for guiding a lead pin 52, at the distal ends thereof. However, no part that corresponds to the stopper piece 66b is formed on the elastic contact piece 160 at the interior of the guide pieces 166a, that is, toward the side of the substantially parallel lead pin contact portions 166.

The slide cover 106 is placed atop a socket housing 102, in which the socket contacts 122 configured as described above are provided within cavities 154, as illustrated in Figure 10A. In Figure 10A, the slide cover 106 is in its initial position prior to being driven. At this time, apertures 110 of the slide cover 106, for the lead pins 52 to be inserted through, are positioned so as to face walls 170. When the lead pins 52 are inserted through the apertures 110, the lead pins 52 are inserted within cutouts 178, which are formed in the walls 170 between the cavities 154. The cutouts 178 may be of a shape in which corresponding portions of the walls 170 are completely removed. Alternatively, the cutouts 178 may be slot-like cutouts having dimensions so as to not interfere with the lead pins 52. That is, portions of the walls 170 that do not interfere with the lead pins 52 may remain on either side of the movement paths of the lead pins 52.

Next, when the slide cover 106 is moved in the direction indicated by arrow 82, the lead pins 52 are moved to the positions illustrated in Figure 10B. At this time, the lead pins 52 are in contact with the elastic contact pieces 160 and do not disengage therefrom. Socket 100, which has no stopper function, is suited for cases in which the number of socket contacts is small and the distance between adjacent socket contacts is large, or for cases in which the drive system is solid and the relative positioning between the socket housing 102 and the slide cover 106 is accurate. The "cases in which the drive system is solid" refer to cases, for example, in which the slide over 106 is formed by overmolding resin on a metal plate having a great number of apertures arranged in a matrix therethrough. In the case that this type of construction is adopted, the slide cover 106 has rigidity and exhibits little compression deformation; therefore, positioning accuracy is good.

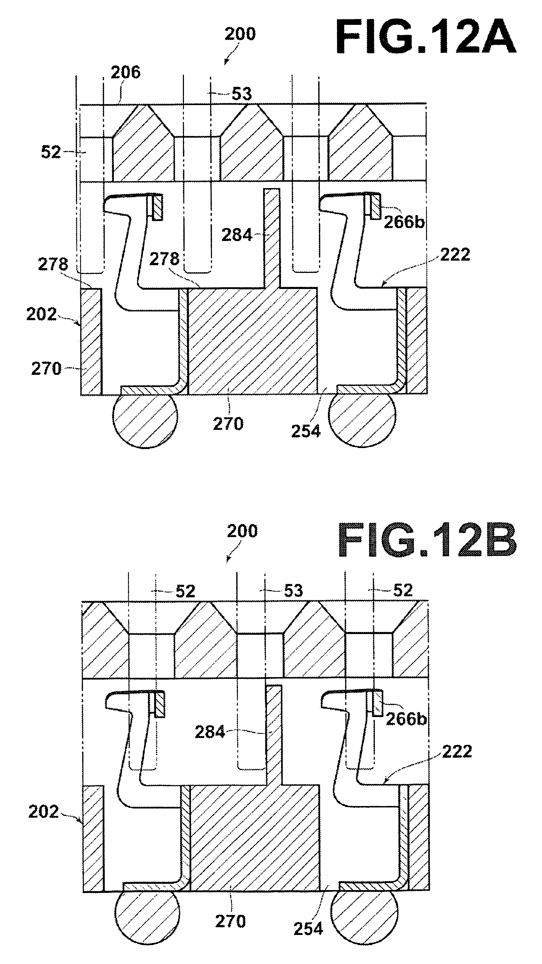

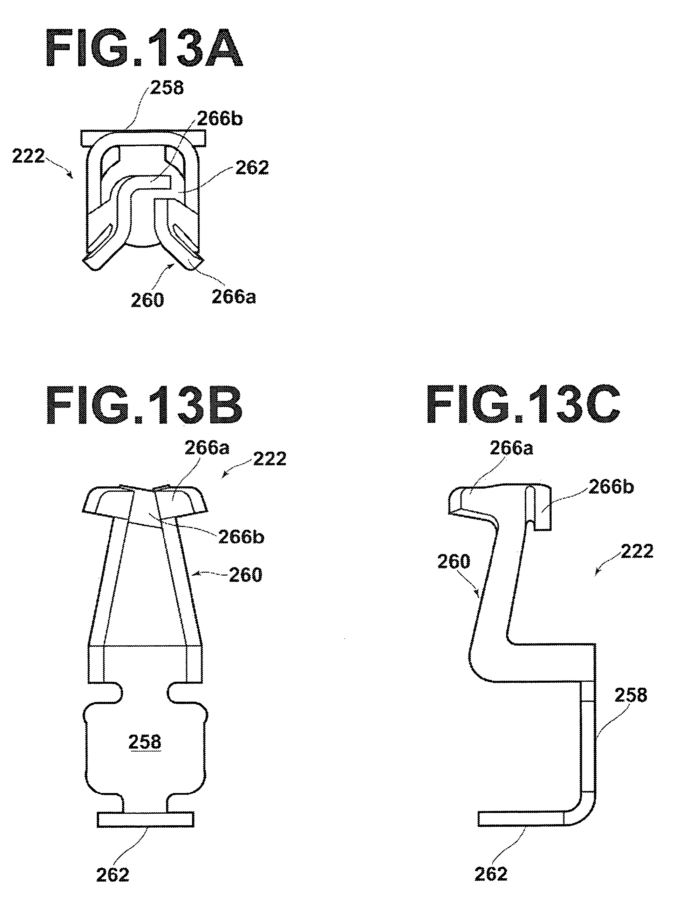

Next, an IC socket 200 according to a second embodiment of the present invention will be described with reference to Figures 12A, 12B, 13A, 13B, and 13C. Figures 12A and 12B are partial magnified sectional views of the IC socket 200, wherein Figure 12A illustrates a state in which a slide cover 206 is in its initial position, and Figure 10B illustrates a state after the slide cover 106 has been driven and moved to its final position. The characteristic features of the IC socket 200 are that socket contacts 222 have stopper pieces 266b, and that a socket housing 202 has stopper walls 284.

Figures 13A, 13B, and 13C illustrate the socket contact 222, which is utilized in the IC socket 200, wherein Figure 13A is a plan view, Figure 13B is a front view, and Figure 13C is a side view. The socket contact 222 is similar to the socket contact 122 of socket 100 and comprises: a base 258; a leg portion 262; and elastic contact pieces 260. Spread open guide pieces 266a are formed at the distal ends of the elastic contact pieces in a manner similar to socket 100. Further, a stopper piece 266b is formed in the interior side of one of the guide pieces 266a so as to cross the gap between the elastic contact pieces 260.

The socket contacts 222, which are configured as described above, are provided in the socket housing 202 as illustrated in Figure 12A. The stopper wall 284, for preventing movement of a lead pin 53, is provided on the upper surface of a wall 270 between cavities 254. The lead pin 53 is a lead pin, from among the lead pins of the IC package 50, which is not employed to establish electrical connections, and which is unavoidably formed in the IC package 50. The lead pin 53 cooperates with the stopper wall 284 of the socket housing 202, to perform positioning. In the initial state of the slide cover 206 illustrated in Figure 12A, the lead pins 52 are positioned within cutouts 278, which are formed in the walls 270.

At the final position, to which the slide cover 206 is driven and moved to from its initial position, the lead pins 52 and the socket contacts 222 are in the relationship illustrated in Figure 12B. In this final position, the lead pins are prevented from further movement by the stopper pieces 266b of the socket contacts 222. In addition, the lead pin 53, which is not utilized to establish electrical contact, abuts the stopper wall 284 and is prevented from further movement thereby. A desired number of the stopper walls 284 may be provided; therefore, there is no possibility that high density arrangement of the socket contacts 222 will be prevented. Note that the protrusion heights of the stopper walls 284 may be an arbitrary height that interferes with the lead pin 53.

Embodiments of the present invention have been described in detail above. However, the present invention is not limited to the embodiments described above. For example, the arrangement of the apertures of the slide cover and the cavities of the socket housing are not limited to a matrix. They may be arranged in any two dimensional pattern, such as a staggered pattern.

## Claims

1. A PGA type IC socket comprising:
a socket housing (2, 202) having a plurality of socket contacts (22, 222) for contacting lead pins (52) of another electrical device, and a plurality of cavities (54, 254), arranged in a two-dimensional array and housing all the socket contacts in the same orientation;
a drive portion (6, 206) for moving the lead pins (52) in a direction perpendicular to the insertion direction thereof;
a pair of narrowly spaced elastic contact pieces (60, 260) of the socket contacts for contacting the lead pins (52) which have been moved in the perpendicular direction; and
cutouts (78, 278) formed in walls (70, 270) of the cavities (54, 254) toward the drive portion (6, 206) such that cavities, which are adjacent to each other in the perpendicular direction, are in communication with each other;
**characterized in that** a stopper (66b, 266b), for preventing disengagement of the lead pins (52) in the perpendicular direction, is formed at the distal end of at least one of the pair of elastic contact pieces (60, 260).

2. A PGA type IC socket as defined in Claim 1, including stopper walls (284) for abutting lead pins (53) which are not involved in electrical contact with the socket contacts (222)

3. A PGA type IC socket as defined in Claim 1 or 2, wherein the dimensions of the cutouts (78, 278) in the insertion direction of the lead pins (52, 53) are greater than the insertion depth of the lead pins (52, 53).

## Patentansprüche

1. PGA-Sockel für IS, der folgendes umfasst:
ein Sockelgehäuse (2, 202), das mehrere Sockelkontakte (22, 222) zum Kontaktieren von Leiterstiften (52) eines anderen elektrischen Geräts und mehrere Hohlräume (54, 254), die in einer zweidimensionalen Gruppierung angeordnet sind und alle Sockelkontakte in der gleichen Ausrichtung aufnehmen, hat,
einen Antriebsabschnitt (6, 206) zum Bewegen der Leiterstifte (52) in einer Richtung senkrecht zur Einsetzrichtung derselben,
ein Paar von mit engem Zwischenraum angeordneten elastischen Kontaktstücken (60, 260) der Sockelkontakte zum Kontaktieren der Leiterstifte (52), die in der senkrechten Richtung bewegt worden sind, und
Ausschnitte (78, 278), die in Wänden (70, 270) der Hohlräume (54, 254) zu dem Antriebsabschnitt (6, 206) hin geformt sind derart, dass Hohlräume, die einander in der senkrechten Richtung benachbart sind, in Verbindung miteinander stehen,
**dadurch gekennzeichnet, dass** am distalen Ende wenigstens eines des Paars von elastischen Kontaktstücken (60, 260) ein Anschlag (66b, 266b) geformt ist, um ein Ausrücken der Leiterstifte (52) in der senkrechten Richtung zu verhindern.

2. PGA-Sockel für IS nach Anspruch 1, der Anschlagwände (284) einschließt, um an Leiterstifte (53) anzustoßen, die nicht in einen elektrischen Kontakt mit den Sockelkontakten (222) einbezogen sind.

3. PGA-Sockel für IS nach Anspruch 1 oder 2, wobei die Abmessungen der Ausschnitte (78, 278) in der Einsetzrichtung der Leiterstifte (52, 53) größer sind als die Einsetztiefe der Leiterstifte (52, 53).

## Revendications

1. Douille à circuit intégré du type PGA, comprenant :
un boîtier de douille (2, 202), comportant plusieurs contacts à douille (22, 222) destinés à contacter des broches conductrices (52) d'un autre dispositif électrique, et plusieurs cavités (54, 254), agencées dans un agencement bidimensionnel et recevant l'ensemble des contacts à douille dans la même orientation ;
une partie d'entraînement (6, 206) pour déplacer les broches conductrices (52) dans une direction perpendiculaire à la direction de leur insertion ;
une paire de pièces de contact élastiques à espacement étroit (60, 260) des contacts à douille pour contacter les broches conductrices (52) ayant été déplacées dans la direction perpendiculaire ; et
des parties découpées (78, 278) formées dans les parois (70, 270) des cavités (54, 254) vers la partie d'entraînement (6, 206), de sorte que les cavités mutuellement adjacentes dans la direction perpendiculaire communiquent les unes avec les autres ;
**caractérisée en ce qu'**un arrêt (66b, 266b) destiné à empêcher un dégagement des broches conductrices (52) dans la direction perpendiculaire, est formé au niveau de l'extrémité distale d'au moins une pièce de la paire de pièces de contact élastiques (60, 260).

2. Douille à circuit intégré du type PGA selon la revendication 1, englobant des parois d'arrêt (284) pour la butée des broches conductrices (53) ne participant pas à l'établissement du contact électrique avec les contacts à douille (222).

3. Douille à circuit intégré du type PGA selon les revendications 1 ou 2, dans laquelle les dimensions des parties découpées (78, 278) dans la direction d'insertion des broches conductrices (52, 53) sont supérieures à la profondeur d'insertion des broches conductrices (52, 53).
